# EUROPEAN PATENT APPLICATION

(11) **EP 4 664 137 A1**
(43) Date of publication of application: **17.12.2025**
(21) Application number: 25181165.9
(22) Date of filing: 05.06.2025
(51) Int. Cl.: G01R 33/36

(54) **MAGNETIC RESONANCE IMAGING APPARATUS**

(30) Priority: 07.06.2024 JP 2024092775
(71) Applicant: FUJIFILM Corporation, Tokyo Tokyo 106-8620 (JP)
(72) Inventor: CHUMAN, Takashi, Tokyo (JP); OTA, Atsushi, Tokyo (JP); ISHII, Koki, Tokyo (JP)
(74) Representative: Dehns Germany Partnerschaft mbB

(57) **Abstract**

An object of the present invention is to provide a magnetic resonance imaging apparatus capable of acquiring a magnetic resonance image through high-quality wireless communication. A magnetic resonance imaging apparatus according to one aspect of the present invention includes: a top plate (210) on which a subject is placed, the top plate being slidable in a longitudinal direction; a plurality of first wireless transceivers (200A, 200B0 connected to a receive coil (110A) for capturing a magnetic resonance image of the subject, the plurality of first wireless transceivers being provided at a plurality of positions of the top plate in the longitudinal direction and moving in the longitudinal direction as the top plate slides; a second wireless transceiver (310A, 310B); and a controller (400) that selects at least one of the plurality of first wireless transceivers and performs wireless communication using the selected first wireless transceiver and the second wireless transceiver.

## Description

### BACKGROUND OF THE INVENTION

### 1. Field of the Invention

The present invention relates to a magnetic resonance imaging apparatus, and particularly to a technique of capturing a magnetic resonance image using wireless communication.

### 2. Description of the Related Art

A physical cable connected to a radio frequency (RF) coil of a magnetic resonance imaging (MRI) apparatus may hinder a setting operation of a user, and also lead to an increase in cable diameter and cost as the number of channels of a receive coil increases. In response to such a situation, a technique of performing wireless communication between the RF coil and a control unit has been developed. For example, US2022/0265496A and JP2021-101852A disclose that wireless communication is performed using a wireless transceiver provided on a top plate.

### SUMMARY OF THE INVENTION

In recent years, with an increase in the total number of channels of the MRI apparatus, the number of signal lines transmitted to a control unit of a machine room through an inside of a bed and a filter box tends to increase. Therefore, it is desired to reduce the number of signal lines through digitization or optical conversion, but analog/digital (AD) conversion and electrical signal/optical signal (EO; conversion from electrical signal to optical signal) conversion in the vicinity of the RF coil are easily affected by a static magnetic field, radio frequency irradiation, a gradient magnetic field, or the like.

In order to address this problem, in the above-described techniques disclosed in US2022/0265496A and JP2021-101852A, the wireless transceiver is provided only at an end part of the top plate opposite to ab MRI apparatus main body. Therefore, the wireless transceiver may be located in an imaging space or in the vicinity of the imaging space depending on an imaging part of a subject, a body position of the subject on the top plate (whether a head or a leg is placed on a main body side), or the like. In this case, the quality of the wireless communication may be deteriorated, resulting in deterioration in the quality of the magnetic resonance image.

As described above, the techniques in the related art have not been capable of capturing a magnetic resonance image through high-quality wireless communication.

The present invention has been made in view of such circumstances, and an object of the present invention is to provide a magnetic resonance imaging apparatus capable of capturing a magnetic resonance image through high-quality wireless communication.

In order to achieve the above-described object, a magnetic resonance imaging apparatus according to a first aspect of the present invention comprises: a top plate on which a subject is placed, the top plate being slidable in a longitudinal direction; a plurality of first wireless transceivers connected to a receive coil for capturing a magnetic resonance image of the subject, the plurality of first wireless transceivers being provided at a plurality of positions of the top plate in the longitudinal direction and moving in the longitudinal direction as the top plate slides; a second wireless transceiver; and a controller that selects at least one of the plurality of first wireless transceivers and performs wireless communication using the selected first wireless transceiver and the second wireless transceiver.

According to the first aspect, the magnetic resonance imaging apparatus is provided with the first wireless transceivers at the plurality of positions in the longitudinal direction (a plurality of first wireless transceivers are provided as a whole), so that the controller can select a first wireless transceiver that is optimal for wireless communication from among the first wireless transceivers having different positions, and thus, it is possible to capture the magnetic resonance image through high-quality wireless communication. **In** addition, since the controller automatically selects the first wireless transceiver and performs the wireless communication, a user of the magnetic resonance imaging apparatus does not need to perform an operation of selecting or designating the first wireless transceiver, and it is possible to reduce a burden on the user.

**In** the first aspect, the expression "plurality of positions of the top plate in the longitudinal direction" means, for example, both end parts in the longitudinal direction, but is not limited to this. The first wireless transceivers need only be provided at a plurality of positions of the top plate in the longitudinal direction, such as an end parts and an intermediate portion. **In** addition, a position of the first wireless transceiver in a lateral direction (direction orthogonal to the longitudinal direction) of the top plate is not particularly limited, but can be at an end part in the lateral direction.

In the first aspect, the controller may select a plurality of first wireless transceivers to perform the wireless communication. The number of the second wireless transceivers may be one or more, and connection between the controller and the second wireless transceiver may be wired or wireless. **In** addition, in the first aspect, the term "receive coil" may be a radio frequency (RF) coil. The controller may perform the wireless communication using either radio waves or light.

In the first aspect, the magnetic resonance imaging apparatus (MRI apparatus) may be a bore-type MRI apparatus (MRI apparatus having a tunnel-shaped imaging space) or an open-type MRI apparatus having an open imaging space.

A second aspect provides the magnetic resonance imaging apparatus according to the first aspect, in which at least one of the first wireless transceivers is provided at an end part of the top plate in the longitudinal direction, and at least one of the first wireless transceivers is provided at the other end part of the top plate in the longitudinal direction. According to the second aspect, even in a case in which wireless communication using the first wireless transceiver at one end part is difficult, wireless communication using the first wireless transceiver at the other end part can be performed. In the second aspect and each of the following aspects, the term "end part" is not limited to an end part in a strict sense, and may be a position away from the end part in a strict sense.

A third aspect provides the magnetic resonance imaging apparatus according to the first or second aspect, in which the plurality of first wireless transceivers are disposed at both end parts of the top plate in the longitudinal direction. According to the third aspect, it is possible to improve a degree of freedom in selecting the first wireless transceiver. In the third aspect, the controller may select a plurality of first wireless transceivers at one end part, may select only the first wireless transceiver at one end part, or may select the first wireless transceivers at both end parts.

A fourth aspect provides the magnetic resonance imaging apparatus according to any one of the first to third aspects, in which at least one of the plurality of first wireless transceivers is connected to the receive coil by wireless communication. According to the fourth aspect, it is possible to reduce the number of cables connecting the receive coil and the first wireless transceiver and to reduce an interference with other devices and an influence on the subject. All of the plurality of first wireless transceivers may be connected to the receive coil by wireless communication.

A fifth aspect provides the magnetic resonance imaging apparatus according to any one of the first to fourth aspects, in which the controller performs the selection based on quality of wireless communication between the first wireless transceiver and the second wireless transceiver. In the fifth aspect, the term "quality" of the wireless communication means, for example, an intensity of radio waves or light waves, an SN ratio, or stability thereof. In addition, the term "quality" may mean a result of actual measurement or may be a result obtained by calculation from the device disposition, a shape, dimensions, device performance, and the like.

A sixth aspect provides the magnetic resonance imaging apparatus according to any one of the first to fifth aspects, in which the controller performs the selection based on a result of preliminary measurement before performing main imaging of the subject. In the sixth aspect, the term "main imaging" means, for example, an act of capturing a magnetic resonance image used for examination or diagnosis of the subject, and the term "preliminary measurement" means, for example, measurement (actual measurement) for the purpose of checking the operation of the **MRI** apparatus or checking image quality.

A seventh aspect provides the magnetic resonance imaging apparatus according to any one of the first to sixth aspects, in which the controller performs the selection in consideration of a relationship between a size of an imaging space of the magnetic resonance imaging apparatus in the longitudinal direction and an interval between the plurality of positions in the longitudinal direction. In the seventh aspect, the expression "size of an imaging space" means, for example, a depth of the tunnel-shaped imaging space, but is not limited to this, and the "size of an imaging space" may be defined in consideration of a size of a magnet or coil for imaging or a size of a housing that houses the magnet or coil. Depending on the relationship between the size of the imaging space of the magnetic resonance imaging apparatus in the longitudinal direction and the interval between the plurality of positions in the longitudinal direction, there may be a case in which the first wireless transceiver is located in the imaging space and a case in which the first wireless transceiver is located outside the imaging space, and such a relationship may affect the quality of the wireless communication. However, according to the seventh aspect, the controller can select the first wireless transceiver in consideration of such a situation.

An eighth aspect provides the magnetic resonance imaging apparatus according to any one of the first to seventh aspects, in which an interval between the plurality of positions in the longitudinal direction is longer than a longitudinal length of an imaging space of the magnetic resonance imaging apparatus, and, in a state in which the subject is imaged, at least one of the plurality of first wireless transceivers is located outside the imaging space. **In** the eighth aspect, the expression "outside the imaging space" means, for example, outside a range of a width (depth) of the imaging space in the longitudinal direction.

A ninth aspect provides the magnetic resonance imaging apparatus according to any one of the first to eighth aspects, in which the controller selects a first wireless transceiver located outside an imaging space of the magnetic resonance imaging apparatus from among the plurality of first wireless transceivers. By selecting the first wireless transceiver located outside the imaging space, it is possible to reduce an influence on the wireless communication caused by a device or the like in the periphery of the imaging space. In the ninth aspect, the expression "outside an imaging space" means, for example, outside a range of a width (depth) of the imaging space in the longitudinal direction, as in the eighth aspect.

A tenth aspect provides the magnetic resonance imaging apparatus according to any one of the first to ninth aspects, in which the controller performs the selection in consideration of an imaging part of the subject. In a case in which the imaging part is different, a position of the top plate during imaging is different accordingly, and thus a positional relationship between the first wireless transceiver and the imaging space changes. According to the tenth aspect, the controller can select the second wireless transceiver in consideration of such a condition.

An eleventh aspect provides the magnetic resonance imaging apparatus according to any one of the first to tenth aspects, in which the controller performs the selection in further consideration of a direction in which the subject is placed on the top plate. In a case in which the placement direction is different, the position of the top plate during imaging is different accordingly, and thus a positional relationship between the first wireless transceiver and the imaging space changes. According to the tenth aspect, the controller can further select the second wireless transceiver in consideration of such a condition.

A twelfth aspect provides the magnetic resonance imaging apparatus according to any one of the first to eleventh aspects, in which the controller operates only the selected first wireless transceiver among the plurality of first wireless transceivers in the wireless communication. The controller may turn off power of a first wireless transceiver other than the selected first wireless transceiver. According to the twelfth aspect, it is possible to improve the quality of the wireless communication by reducing noise and preventing malfunctions and to reduce power consumption.

A thirteenth aspect provides the magnetic resonance imaging apparatus according to any one of the first to twelfth aspects, in which the controller selects a plurality of first wireless transceivers from among the plurality of first wireless transceivers, and sets a priority order in the wireless communication for the selected first wireless transceivers to perform the wireless communication based on the priority order. In the thirteenth aspect, the controller can set the priority order in consideration of at least one of the quality of the wireless communication, the imaging part, or the placement direction of the subject on the top plate. In addition, the controller can select a required number of the first wireless transceivers according to the priority order.

A fourteenth aspect provides the magnetic resonance imaging apparatus according to any one of the first to thirteenth aspects, in which, in a case in which the wireless communication is disconnected or quality of the wireless communication is deteriorated, the controller selects at least one of first wireless transceivers other than the selected first wireless transceiver among the plurality of first wireless transceivers and performs the wireless communication. As a result, even in a case in which the wireless communication via the first wireless transceiver initially selected is disconnected or the quality of the wireless communication is deteriorated, it is possible to select another first wireless transceiver and continue the wireless communication.

A fifteenth aspect provides the magnetic resonance imaging apparatus according to any one of the first to fourteenth aspects, in which the controller causes an output device to output information indicating the selected first wireless transceiver among the plurality of first wireless transceivers. The output may be performed by a display or other display devices, a light emitting device, or may be performed by a voice output device. As a result, the user can know which first wireless transceiver is selected.

A sixteenth aspect provides the magnetic resonance imaging apparatus according to any one of the first to fifteenth aspects, in which the first wireless transceiver is housed in the top plate or is integrated with the top plate. According to the sixteenth aspect, it is possible to reduce probability of collision or interference between the first wireless transceiver and a body of the user or the subject, an instrument, a cord, or the like.

A seventeenth aspect provides the magnetic resonance imaging apparatus according to any one of the first to sixteenth aspects, in which the controller causes an output device to output information indicating quality of the wireless communication. The output may be performed by a display or other display devices, a light emitting device, or may be performed by a voice output device. As a result, the user can know the quality of the wireless communication.

An eighteenth aspect provides the magnetic resonance imaging apparatus according to any one of the first to seventeenth aspects, in which the controller performs the wireless communication using light.

As described above, with the magnetic resonance imaging apparatus of the aspect of the present invention, it is possible to capture a magnetic resonance image through high-quality wireless communication.

### BRIEF DESCRIPTION OF THE DRAWINGS

Fig. 1 is a schematic diagram showing a main configuration of a magnetic resonance imaging apparatus.
Fig. 2 is an external perspective view showing an installation example of a wireless transceiver in a first embodiment.
Figs. 3A and 3B are diagrams showing a state in which a wireless transceiver is installed on a top plate.
Figs. 4A and 4B are diagrams showing a disposition example of a filter box.
Fig. 5 is a diagram showing a state of wireless communication in the first embodiment.
Fig. 6 is a block diagram showing a configuration of a control device.
Fig. 7 is a flowchart showing processing of selection of a wireless transceiver.
Figs. 8A to 8D are diagrams showing a state of wireless communication according to an imaging part.
Figs. 9A to 9D are other diagrams showing a state of wireless communication according to an imaging part.
Figs. 10A to 10D are diagrams showing a display example of quality of wireless communication.
Figs. 11A to 11C are other diagrams showing a display example of quality of wireless communication.
Fig. 12 is a flowchart showing processing in a case in which wireless communication is disconnected or quality of the wireless communication is deteriorated.
Fig. 13 is a diagram showing an installation example of a wireless transceiver in a second embodiment.
Fig. 14 is a diagram showing a state in which a wireless transceiver is installed on a top plate in the second embodiment.
Fig. 15 is a diagram showing a state of wireless communication in the second embodiment.
Fig. 16 is a diagram showing an installation example of a wireless transceiver in a third embodiment.
Fig. 17 is a diagram showing a state of wireless transmission and reception in the third embodiment.

### DESCRIPTION OF THE PREFERRED EMBODIMENTS

Hereinafter, preferred embodiments of a magnetic resonance imaging apparatus according to the present invention will be described with reference to the accompanying drawings. The accompanying drawings do not show exact shapes and dimensions of components. In addition, in some cases, a part of the components is not shown for convenience of description.

### First Embodiment

### Configuration of Magnetic Resonance Imaging Apparatus

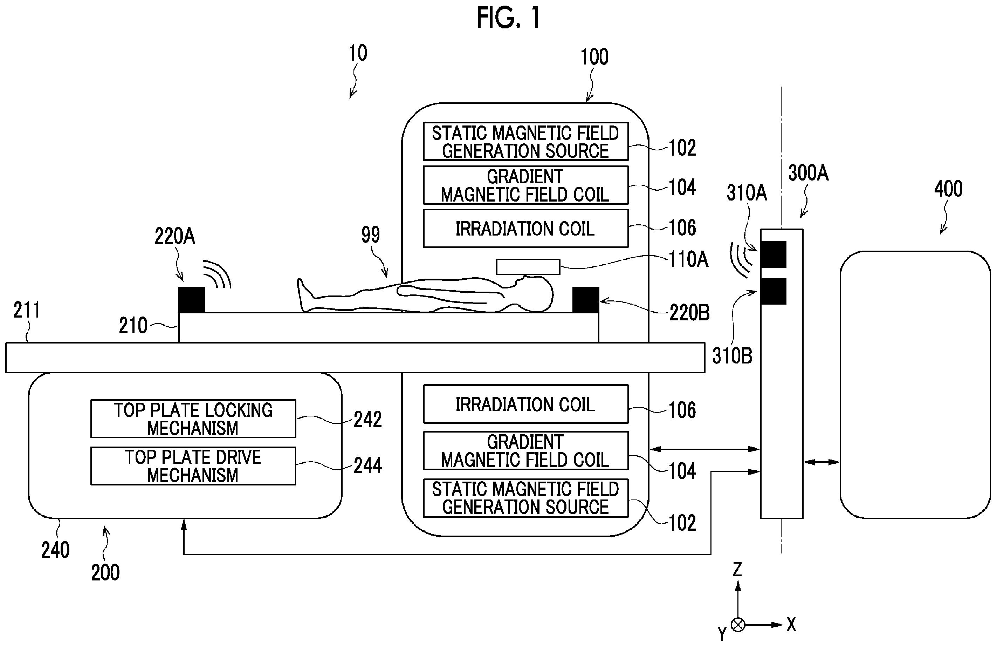

First, an overall configuration of a magnetic resonance imaging apparatus system will be described. Fig. 1 is a schematic diagram showing a main configuration of a magnetic resonance imaging apparatus 10 (magnetic resonance imaging apparatus, MRI apparatus) according to a first embodiment. As shown in Fig. 1, the magnetic resonance imaging apparatus 10 comprises an imaging apparatus main body 100, a bed device 200, a filter box 300A, and a control device 400 (controller). The magnetic resonance imaging apparatus 10 comprises a power supply and the like (not shown) in addition to these elements. In addition, among components of the magnetic resonance imaging apparatus 10, the imaging apparatus main body 100 and the bed device 200 are installed in a location (examination room, imaging room, or the like) that is radio wave-shielded (and magnetic field-shielded as necessary), and the control device 400 is installed in a location other than the examination room or the like and performs communication via the filter box 300A.

### Imaging Apparatus Main Body

The imaging apparatus main body 100 comprises a static magnetic field generation source 102, a gradient magnetic field coil 104, and an irradiation coil 106. The imaging apparatus main body 100 may be a bore-type apparatus having a tunnel-shaped or cylindrical-shaped imaging space, or may be an open-type apparatus having an open imaging space. The static magnetic field generation source 102 is a coil for generating a uniform static magnetic field in a static magnetic field space in which a subject 99 (subject) is accommodated, and the gradient magnetic field coil 104 is a coil for generating a gradient magnetic field in a superimposed manner in the static magnetic field space. The static magnetic field generation source 102 may be configured of a superconducting magnet (superconducting coil) or may be configured of a normal conductive magnet. The irradiation coil 106 is a coil for irradiating the subject 99 with an RF pulse in order to cause nuclear magnetic resonance to occur in nuclear spins of atoms constituting a biological tissue of the subject 99.

A receive coil 110A (RF coil, receive coil) is configured as, for example, a unit comprising a plurality of receive coil elements (element coils) that are formed in a loop shape and that are disposed in a two-dimensional array, and receives a signal from the subject 99. An image of the subject 99 is captured (reconstructed) based on the signal received by the receive coil 110A. In the magnetic resonance imaging apparatus 10, as the receive coil 110A, a coil for imaging various parts such as a head, a spine, an abdomen, a leg, and an arm can be used. The number of coils used in one imaging may be one or plural, and a plurality of coils (for example, a coil for a chest and a coil for abdomen) for imaging different parts may be used simultaneously. In the first embodiment and second and third embodiments described below, the receive coils with different imaging parts are described as receive coils 110A to 110G, but in the following description, these may be collectively referred to as a "receive coil 110".

In the first embodiment and the second embodiment described below, the receive coil 110 and a first wireless transceiver such as a wireless transceiver 220A are connected by a cable (wired) (not shown), but as described in the third embodiment described below, the receive coil 110 and the wireless transceiver 220 may be connected wirelessly. In the accompanying drawings, wireless transceivers with different installation positions are described as wireless transceivers 220A to 220D (a plurality of first wireless transceivers), but these may be collectively referred to as a "wireless transceiver 220".

### Bed Device

The bed device 200 comprises a bed main body 240, and a top plate receiver 211 is fixed to the bed main body 240. The top plate receiver 211 holds the top plate 210 (top plate). The bed main body 240 comprises a top plate drive mechanism 244, and the top plate drive mechanism 244 slides the top plate 210 in a longitudinal direction (±X direction in Fig. 1). As the top plate drive mechanism 244, a mechanism such as a rack and pinion, a roller, a wire, or a belt can be used. By sliding the top plate 210, the imaging part of the subject 99 can be moved into the imaging space or the subject 99 can be retracted outside the imaging space.

A top plate locking mechanism 242 locks the top plate 210 to prevent it from sliding or unlocks the top plate 210 to allow it to slide. As the top plate locking mechanism 242, a mechanism can be adopted in which a locking pin is connected to a solenoid coil via a spring, and the locking pin is retracted or protruded by contracting or expanding the spring by turning on/off energization to the solenoid coil. In addition, a mechanism may be adopted in which a magnetic body on the top plate 210 side is attracted or released by turning on/off energization to an electromagnet provided in the top plate receiver 211.

The bed device 200 is connected to the control device 400 via the filter box 300A and is operated under the control of the control device 400.

### Wireless Transceiver (First Wireless Transceiver)

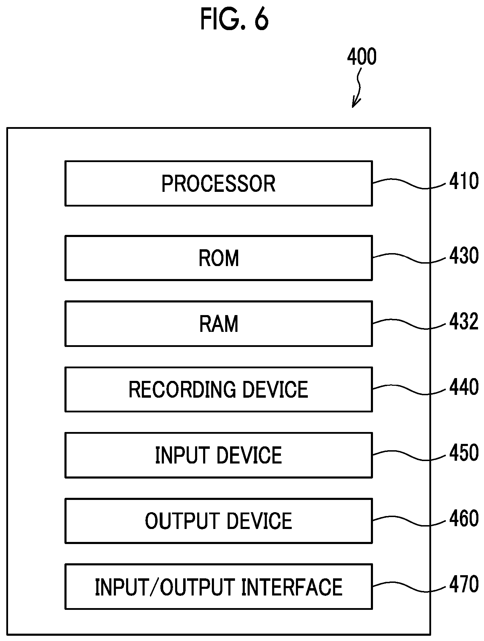

In Fig. 1, the wireless transceivers 220A and 220B (a plurality of first wireless transceivers) are provided at both end parts of the top plate 210 (an end part on the -X side which is one end part and an end part on the +X side which is the other end part), that is, at a plurality of positions in the longitudinal direction of the top plate 210, and the wireless transceivers 220A and 220B move in the longitudinal direction (±X direction) as the top plate 210 slides. An AD converter or an optical converter is connected to the wireless transceivers 220A and 220B (see the description of Fig. 6 described below).

In Fig. 1, a case in which the wireless transceivers 220A and 220B are installed at both end parts of the top plate 210 in the longitudinal direction has been described, but the disposition position of the wireless transceiver (first wireless transceiver) is not limited to such an aspect. The wireless transceivers need only be provided at a plurality of positions in the longitudinal direction of the top plate, such as an end parts and an intermediate portion. In addition, in the installation of the wireless transceiver, the term "end part" is not limited to an end part in a strict sense, and may be a position away from the end part in a strict sense.

### Disposition of Wireless Transceiver

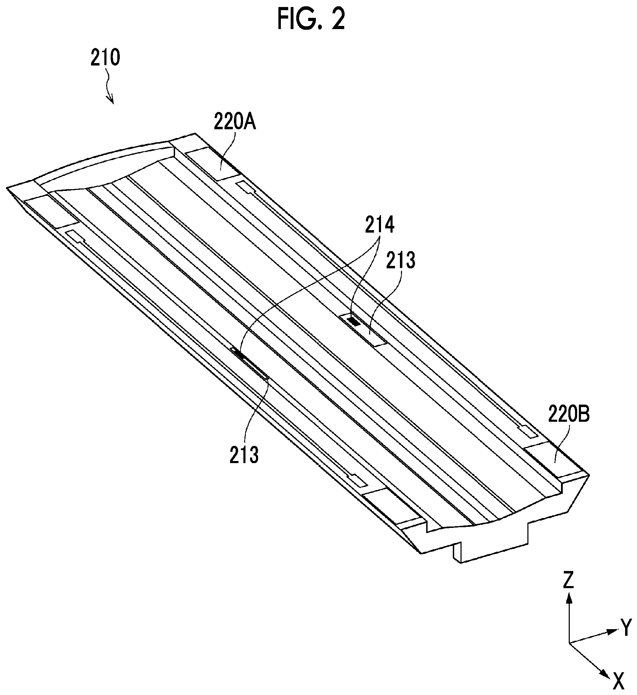

Fig. 2 is an external perspective view showing an installation example of the wireless transceivers 220A and 220B (first wireless transceivers). As shown in Fig. 2 and as described above, the wireless transceiver 220A is disposed at an end part on the -X side of the top plate 210, and the wireless transceiver 220B is disposed at an end part on the +X side of the top plate 210. That is, the plurality of first wireless transceivers are provided at a plurality of positions in the longitudinal direction of the top plate 210. In the example of Fig. 2, the wireless transceivers 220A and 220B are installed at an end part on the +Y side of the top plate 210, but the positions in the Y direction may be other positions (end parts on the -Y side, and the like).

In Fig. 2, an opening 213 is provided in the top plate 210, and a connector 214 slides the opening 213 by a sliding mechanism (not shown). The positions, numbers, and sizes of the openings and the connectors may be different from those in the example of Fig. 2. In addition, the position of the connector 214 may be fixed. In a case in which the receive coil 110 and the wireless transceiver 220 are connected in a wired manner, a cable of the receive coil 110 can be connected to the connectors 214. The connector 214 is connected to the wireless transceiver 220 by a cable (not shown).

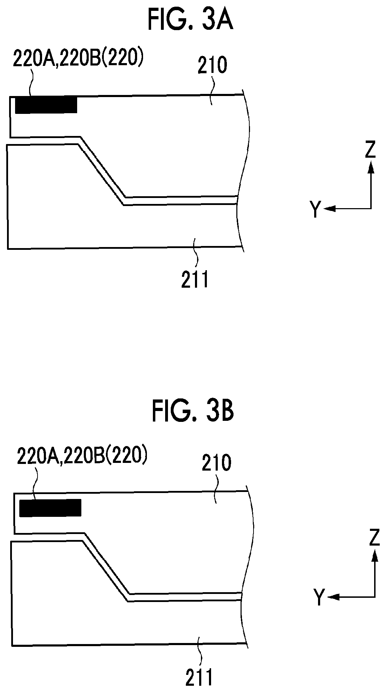

In the example of Fig. 1 described above, for convenience, the wireless transceivers 220A and 220B are described as protruding from the top plate 210 in the +Z direction, but, in consideration of the possibility of an interference with various devices or cables or contact with the subject 99, it is preferable that the wireless transceivers 220 (first wireless transceivers) are housed in the top plate 210 or integrated with the top plate 210 so as not to protrude from the top plate 210. Figs. 3A and 3B are diagrams showing an example of installation of such a wireless transceiver 220. In the example shown in Fig. 3A, an upper surface of the wireless transceiver 220 is flush with an upper surface of the top plate 210, and in the example shown in Fig. 3B, the wireless transceiver 220 is present inside the top plate 210. The expression "the wireless transceiver 220 is housed in the top plate 210 or integrated with the top plate 210" may mean that the wireless transceiver 220 is attachable to and detachable from the top plate 210 by a connector (not shown).

### Relationship between Interval between Wireless Transceivers and Size of Imaging Space

In the first embodiment, a length of the top plate 210 in the longitudinal direction (±X direction) is, for example, 2,500 mm, and a size of the imaging space (here, for convenience, a length of the imaging apparatus main body 100 in the ±X direction) is, for example, 2,000 mm. In addition, it is assumed that the wireless transceivers 220A and 220B are installed at both end parts of the top plate 210 in the longitudinal direction. In this case, an interval between the installation positions of the wireless transceivers 220A and 220B in the longitudinal direction (an interval between the plurality of positions for the first wireless transceivers) is longer than a length of the imaging space of the magnetic resonance imaging apparatus 10 in the longitudinal direction, and the wireless transceivers 220A and 220B are installed at both end parts of the top plate 210, so that at least one of the wireless transceiver 220A or the wireless transceiver 220B (a plurality of first wireless transceivers) is located outside the imaging space in a state in which the subject 99 is imaged. A processor 410 can consider such a relationship in a case of selecting the wireless transceiver 220 (for example, instead of or in addition to the determination in steps S120 to S140 described below), and can select the wireless transceiver 220 located outside the imaging space to perform high-quality (signal intensity, SN ratio, stability, and the like) wireless communication and capture the magnetic resonance image. The length of the top plate 210 and the size of the imaging space described above are examples, and the length and the size may be different from the above. For example, the size of the imaging space may be about 1,800 mm or may be about 2,400 mm.

### Filter Box

The filter box 300A is provided between an examination room or the like in which the imaging apparatus main body 100 and the bed device 200 are installed and the control device 400, and cables connected to the imaging apparatus main body 100 and the bed device 200 are connected to the control device 400 via the filter box 300A. The filter box 300A and the control device 400 may be connected in a wired manner or in a wireless manner. In the accompanying drawings, filter boxes with different installation positions are described as filter boxes 300A and 300B, but these may be collectively referred to as a "filter box 300".

The filter box 300A is provided with wireless transceivers 310A and 310B (second wireless transceivers), and the control device 400 selects at least one of the wireless transceiver 200A or the wireless transceiver 200B (a plurality of first wireless transceivers) and performs wireless communication using the selected first wireless transceiver and the second wireless transceivers. The control device 400 may use only one of the wireless transceivers 310A and 310B or both of them in the wireless communication. The control device 400 can determine which of the wireless transceivers 310A and 310B, or both, to use depending on the size and number of an examination part, the number and communication speed of the wireless transceivers 220 to be operated, the amount of data, and the like. Although the wireless transceivers 310A and 310B are described in the accompanying drawings, these may be collectively referred to as a "wireless transceiver 310". In a case of wireless communication using light, the wireless transceiver 310 comprises an optical converter that performs conversion (EO conversion and OE conversion) between an optical signal and an electrical signal.

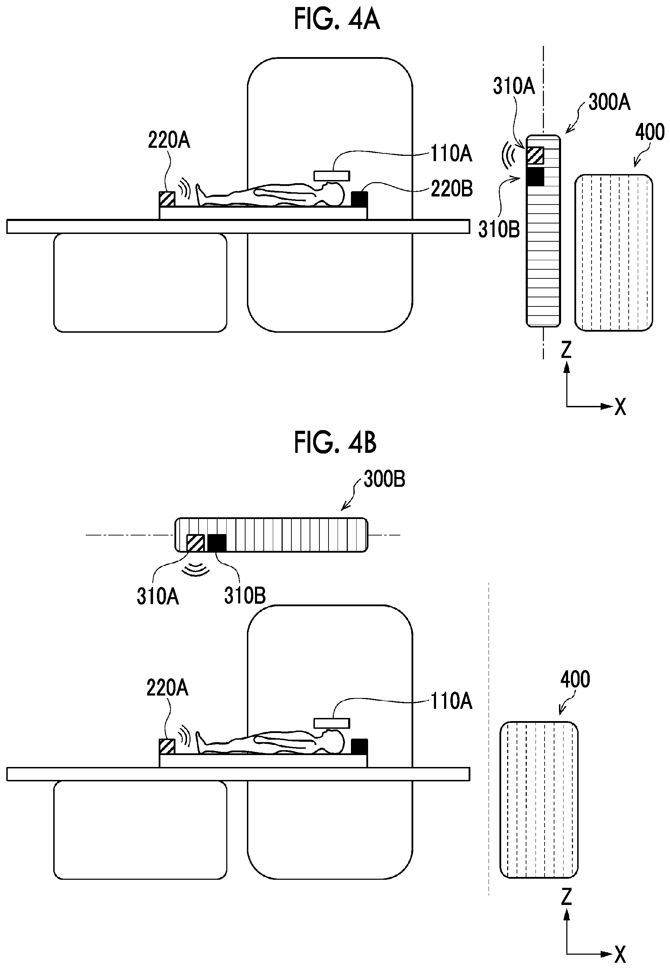

Figs. 4A and 4B are diagrams showing a disposition example of the filter box 300 and the wireless transceiver 310. Fig. 4A shows a state in which the filter box 300A is installed on a wall portion of the examination room, and Fig. 4B shows a state in which the filter box 300B is provided on a ceiling portion of the examination room. Figs. 4A and 4B show a state in which wireless communication is performed between the wireless transceiver 220A and the wireless transceiver 310A.

### Content and Method of Wireless Communication

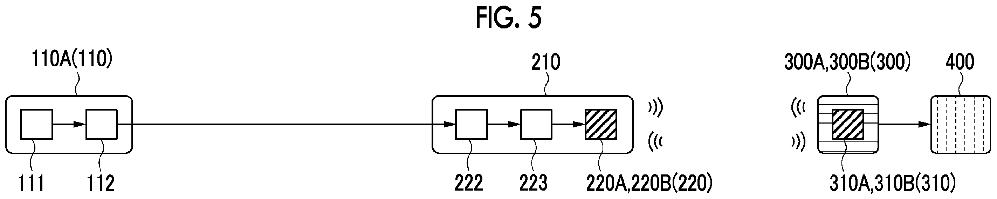

In the magnetic resonance imaging apparatus 10, various control signals are transmitted from the control device 400 to the wireless transceiver 220 via the wireless transceiver 310, and an image signal and a device operation status are transmitted from the wireless transceiver 220 to the control device 400 via the wireless transceiver 310 (bidirectional communication; see Fig. 5 and related description). The wireless communication may be performed by radio waves or light. That is, the wireless transceiver 220 and the wireless transceiver 310 may be devices that perform wireless communication using radio waves or devices that perform wireless communication using light.

The wireless communication using light can be performed by visible light, infrared rays, or ultraviolet rays, and a signal is transmitted by turning on/off a light-emitting diode (LED), a laser light source, or the like. The communication using light has advantages such as higher speed communication than wireless communication using general radio waves, and no influence on a living body or a peripheral device like radio waves. For wireless communication using visible light (visible light communication (VLC)), a technique called "light fidelity (Li-Fi)" has been proposed, and a standard is defined in IEEE802.11, 802.15.7, and the like.

### State of Wireless Communication

Fig. 5 is a conceptual diagram showing a state of the wireless communication in the first embodiment. As shown in Fig. 5, the receive coil 110A (receive coil 110; RF coil unit) comprises a plurality of element coils 111 and an amplifier 112, and is connected to the top plate 210 by a cable (not shown) (and the connector 214 shown in Fig. 2). A signal from the receive coil 110A (receive coil 110) acquired via the cable is converted into a digital optical signal by an analog-to-digital (AD) converter 222 and an optical converter 223, and is transmitted by the wireless transceiver 220. Since the wireless communication is bidirectionally performed, the wireless transceiver 220 transmits and receives an optical signal, and the optical converter 223 performs EO conversion (conversion from an electrical signal to an optical signal) and OE conversion (conversion from an optical signal to an electrical signal). In a case of wireless communication using radio waves, the optical converter 223 is not necessary. The signal transmitted from the wireless transceiver 220 is received by the wireless transceiver 310 provided in the filter box 300 and is input to the control device 400 (input/output interface 470, processor 410; see Fig. 6). The control signal from the control device 400 is transmitted through a path opposite to the above-described path.

### Control Device

Fig. 6 is a diagram showing a configuration of the control device 400. The control device 400 includes the processor 410, a read only memory (ROM) 430, a random access memory (RAM) 432, a recording device 440, an input device 450, an output device 460, and the input/output interface 470.

### Processor

The processor 410 has, as main functions, a wireless transceiver selection function, a wireless transceiver control function, a bed control function, an imaging control function, a wireless communication control function, and an input/output control function. The processing by these functions will be described in detail below. The processor 410 may have other functions.

The processor 410 is configured of, for example, various processors and electric circuits, such as a central processing unit (CPU), a graphics processing unit (GPU), a field programmable gate array (FPGA), and a programmable logic device (PLD). The functions of the processor 410 do not necessarily correspond one-to-one to the processors and electric circuits. A plurality of functions may be realized by one processor or the like, or one function may be realized by a plurality of processors or the like. In a case in which these processors and electric circuits execute software (program), codes readable by a computer in the software to be executed are recorded on a non-transitory and tangible recording medium such as the ROM 430, and the computer refers to the software. This term "computer" refers to, for example, various processors or electric circuits constituting the processor, and/or a combination thereof.

The software recorded on the non-transitory and tangible recording medium includes a program for acquiring an image signal of a magnetic resonance image, reconstructing the magnetic resonance image, and performing various types of image processing, and data used in executing the program. The code may be recorded on a non-transitory and tangible recording medium, such as a flash ROM or an electronically erasable and programmable read only memory (EEPROM), instead of the ROM 430. The above-described "non-transitory and tangible recording medium" does not include a non-tangible recording medium such as a carrier wave signal or a propagation signal itself. In a case of processing using software, the RAM 432 is used as a transitory storage region or a work region.

### Recording Device

The recording device 440 is composed of a recording medium (non-transitory and tangible recording medium) such as a hard disk, a semiconductor memory, and various magnetooptical recording media, and a controller thereof, and records or stores various types of information. The information recorded on the recording device 440 is, for example, data acquired by the magnetic resonance imaging apparatus 10, a magnetic resonance image (tomographic image or three-dimensional image) obtained by reconstructing the data, an image obtained by performing various types of image processing on the magnetic resonance image, accessory information of the magnetic resonance image, findings or reports for the magnetic resonance image, plans and results of imaging or examination, information indicating an operation status of the wireless transceiver 220 or the wireless transceiver 310, information indicating the selected wireless transceiver, and information indicating the quality of wireless communication, but is not limited to these examples.

### Input Device

The input device 450 includes a device such as a keyboard or a mouse, and the user can perform an operation necessary for the processing of the magnetic resonance imaging apparatus 10 via these devices. The input device 450 may comprise a microphone (not shown) for voice input. In this case, it is assumed that the processor 410 has a voice recognition function.

### Output Device

The output device 460 (output device) includes a display device such as a liquid crystal display, and can display data recorded on the recording device 440 and a processing result thereof (including a reconstructed image), information indicating an operation status of the wireless transceiver 220 or the wireless transceiver 310, information indicating the selected wireless transceiver, information indicating the quality of wireless communication, information input by the user, and the like. A touch panel type display may be used as the display device and the input device 450. Information (for example, a message to the user) may be output using a speaker (not shown). In addition, the output device 460 may comprise a printer that prints out the above information.

### Selection of Wireless Transceiver

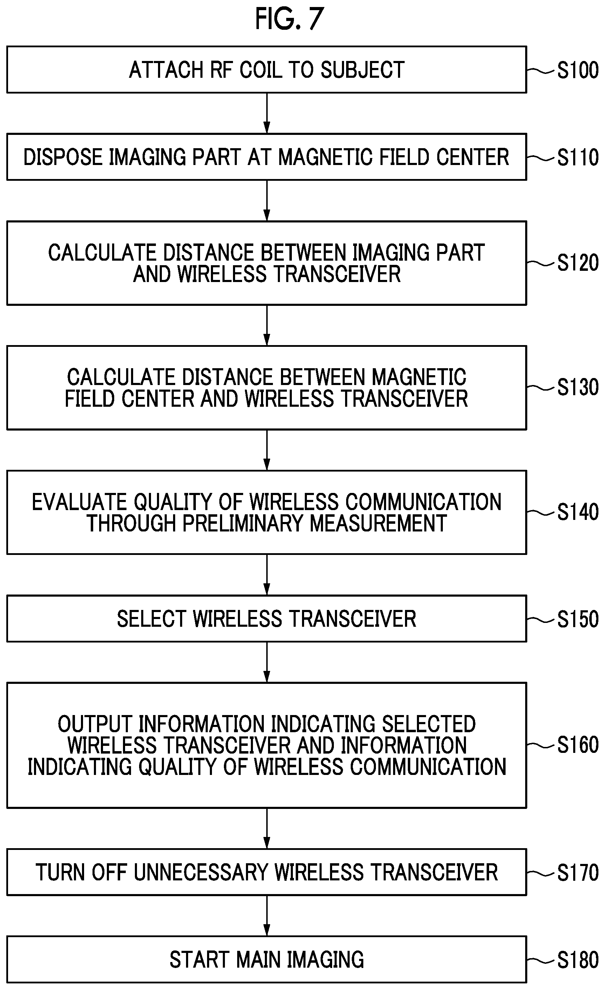

Fig. 7 is a flowchart showing processing from selection of the wireless transceiver (wireless transceiver 220; first wireless transceiver) to start of main imaging.

A user such as a technician attaches the receive coil 110 (RF coil; coil) to the imaging part of the subject 99 in accordance with an examination plan or an imaging condition (step S100). Subsequent processing is performed by the magnetic resonance imaging apparatus 10.

The processor 410 (control device 400; controller) slides the top plate 210 in the +X direction via the top plate drive mechanism 244 to dispose the imaging part at the magnetic field center (center of the imaging space) (step S110). In this case, as will be described in detail below, a positional relationship between the top plate 210 and the imaging space varies depending on the imaging part or a body position of the subject 99 (the placement direction on the top plate 210; which of the head and the leg is placed on the +X side), and thus, which wireless transceiver (first wireless transceiver) has to be selected varies. For example, the processor 410 may perform the selection in consideration of the imaging part of the subject 99, and may perform the selection in further consideration of the direction in which the subject 99 is placed on the top plate 210. In the present embodiment, it is assumed that the wireless transceivers 220A and 220B are installed at both ends of the top plate 210 as shown in Fig. 2.

Steps S120 to S140 are processes for selecting the wireless transceiver. All of these processes do not have to be performed, and any one or two processes may be performed to select the wireless transceiver (at least one of the processes in steps S120 to S140 need only be performed). In addition, in a case in which a plurality of processes are performed, the order of the processes does not have to be the order shown in Fig. 7. Which process is to be performed may be determined according to a user operation via the input device 450, or the processor 410 (control device 400) may automatically perform a predetermined process without depending on the user operation. In a case in which a plurality of processes are performed, the result of which process is to be given priority in selecting the wireless transceiver may be determined in accordance with the user operation, or the processor 410 (control device 400) may make the determination without depending on the user operation.

The processor 410 (control device 400) calculates a distance between the imaging part and the wireless transceivers 220A and 220B (step S120). This distance can be calculated based on the imaging part, the body position of the subject 99, the size of the top plate 210, the installation positions of the wireless transceivers 220A and 220B, the position of the receive coil 110A (receive coil 110), the type of coil to be used, and the like. In consideration of the length and routing of the cable, it is preferable that the processor 410 selects a wireless transceiver having a short distance to the imaging part. As described above, the connector 214 is slidable within a range of the opening 213, and the processor 410 can shorten the length of the necessary cable and facilitate the routing by sliding the connector 214.

The processor 410 calculates a distance between the magnetic field center (center of the imaging space) and the wireless transceivers 220A and 220B (step S130). This distance can be calculated based on the imaging part, the body position of the subject 99, the size of the top plate 210, the installation positions of the wireless transceivers 220A and 220B, and the like. It is preferable that this distance is long in consideration of the influence of the magnetic field on the wireless communication, and it is preferable that the processor 410 selects a wireless transceiver outside the imaging space.

The processor 410 evaluates the quality of the wireless communication through preliminary measurement (step S140). The quality of the wireless communication is, for example, an intensity of light (an intensity of radio waves in a case of wireless communication using radio waves), an SN ratio, or stability thereof. It is preferable that the preliminary measurement is performed by actual measurement before the main imaging is performed. In a case in which the quality of the wireless communication is low, the processor 410 may output a warning indicating that the quality of the wireless communication is low or a message prompting to change the body position of the subject 99 to the output device 460 (display on a display device, turning on or off warning light, or the like, voice output from a speaker, or the like).

The processor 410 (control device 400) selects the wireless transceiver 220 (first wireless transceiver) based on the results of steps S120 to S140 (step S150). According to the first embodiment, by selecting the wireless transceiver as described above, it is possible to perform high-quality wireless communication and acquire the magnetic resonance image.

It is preferable that the processor 410 causes the output device 460 to output information indicating the selected wireless transceiver (display on a display device, voice output from a speaker, and the like). The display can be made by one or more of a character, a number, a figure, and a symbol, and these may be colored. In addition, in a case of making a selection, it is preferable that the processor 410 sets a priority order in wireless communication for a plurality of wireless transceivers, and it is more preferable that the priority order is set by prioritizing the quality of the wireless communication. As will be described below, in a case in which the wireless communication is disconnected or the quality of the wireless communication is deteriorated, it is possible to cope with this issue based on this priority order. The processor 410 can record the priority order in the recording device 440 or cause the output device 460 to output (display on the display device) the priority order.

### Selection of Wireless Transceiver According to Imaging Part (Part 1)

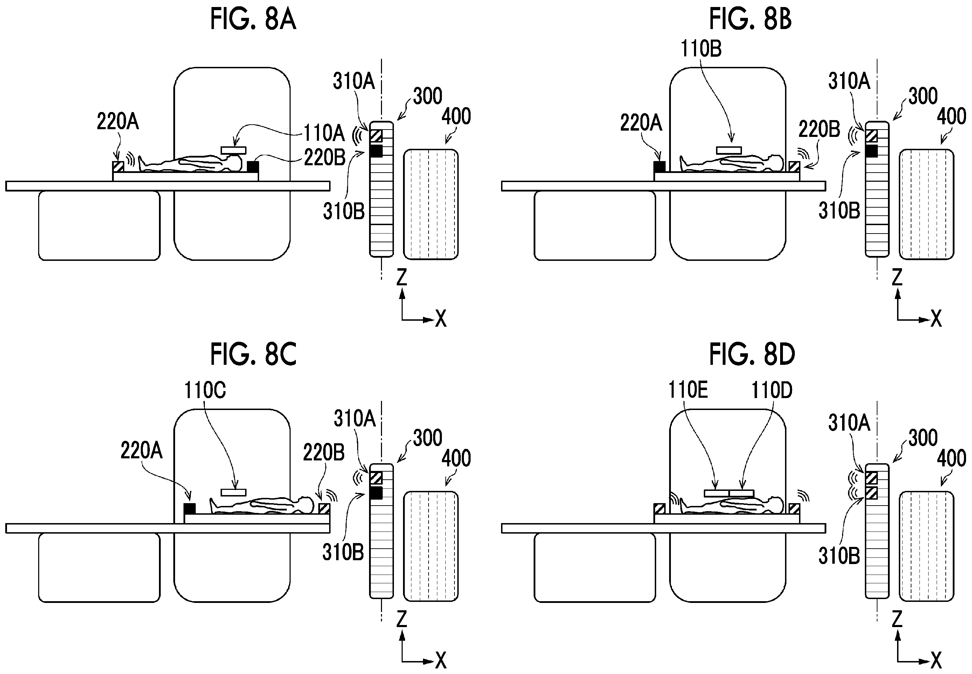

Figs.8A to 8D are diagrams showing a state in which the wireless transceiver is selected according to an imaging part, and show an example in a case in which the subject 99 is moved to an imaging space in "Head First" (a state in which the subject 99 is placed on the top plate in a body position in which a head is close to the imaging apparatus main body 100 before the subject 99 is moved to the imaging space). In Figs. 8A to 8D and subsequent drawings, non-selected wireless transceivers and non-operating wireless transceivers are displayed by filling the wireless transceiver section (an example of identification display).

Fig. 8A is an example of a case in which the head is imaged. In this example, although the wireless transceiver 220B is closer to the imaging part, since the wireless transceiver 220B is located in the imaging space and the wireless transceiver 220A is farther from the magnetic field center (as a result, the quality evaluation result in the preliminary measurement is also determined to be better for the wireless transceiver 220A), so that the processor 410 selects the wireless transceiver 220A (first wireless transceiver). In Figs. 8A to 8C, a state in which the processor 410 selects the wireless transceiver 310A (second wireless transceiver) is shown.

Fig. 8B is an example of a case in which the abdomen is imaged. In this example, the distance between the wireless transceiver 220A and the imaging part is approximately the same as the distance between the wireless transceiver 220B and the imaging part, and the distance between the wireless transceiver 220A and the magnetic field center is approximately the same as the distance between the wireless transceivers 220B and the magnetic field center. Further, although both the wireless transceivers 220A and 220B are outside the imaging space, the wireless transceiver 220B is closer to the wireless transceiver 310 and there is no obstacle (as a result, the quality evaluation result in the preliminary measurement is also determined to be better for the wireless transceiver 220B), so that the processor 410 selects the wireless transceiver 220B.

Fig. 8C is an example of a case in which the leg is imaged. In this example, although the wireless transceiver 220A is closer to the imaging part, the wireless transceiver 220A enters the imaging space and is closer to the magnetic field center. On the other hand, the wireless transceiver 220B is far from the magnetic field center and is outside the imaging space (as a result, the quality evaluation result in the preliminary measurement is also determined to be better for the wireless transceiver 220B), so that the processor 410 selects the wireless transceiver 220B.

Fig. 8D is an example of wide area imaging (here, it is assumed that the chest and abdomen are imaged). In this example, the distance between the wireless transceiver 220A and the imaging part is approximately the same as the distance between the wireless transceiver 220B and the imaging part, and the distance between the wireless transceiver 220A and the magnetic field center is approximately the same as the distance between the wireless transceivers 220B and the magnetic field center. Further, although both the wireless transceivers 220A and 220B are outside the imaging space, in this example, since two receive coils 110D and 110E are used, the processor 410 selects the wireless transceivers 220A and 220B (first wireless transceivers) and selects the wireless transceivers 310A and 310B in consideration of the communication amount.

### Selection of Wireless Transceiver According to Imaging Part (Part 2)

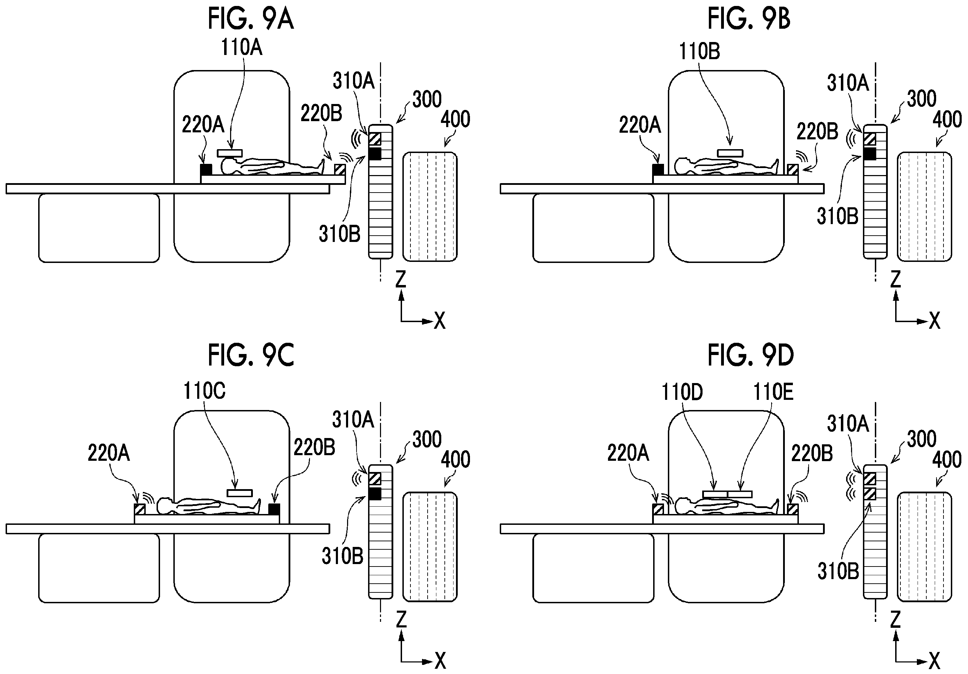

Figs.9A to 9D are diagrams showing a state in which the wireless transceiver is selected according to an imaging part, and show an example in a case in which the subject 99 is moved to an imaging space in "Foot First" (a state in which the subject 99 is placed on the top plate in a body position in which a leg is close to the imaging apparatus main body 100 before the subject 99 is moved to the imaging space).

Fig. 9A is an example of a case in which the head is imaged. In this example, although the wireless transceiver 220A is closer to the imaging part, since the wireless transceiver 220A is located in the imaging space and the wireless transceiver 220B is farther from the magnetic field center (as a result, the quality evaluation result in the preliminary measurement is also determined to be better for the wireless transceiver 220B), so that the processor 410 selects the wireless transceiver 220B (first wireless transceiver). In Figs. 9A to 9C, a state in which the processor 410 selects the wireless transceiver 310A (second wireless transceiver) is shown.

Fig. 9B is an example of a case in which the abdomen is imaged. In this example, the distance between the wireless transceiver 220A and the imaging part is approximately the same as the distance between the wireless transceiver 220B and the imaging part, and the distance between the wireless transceiver 220A and the magnetic field center is approximately the same as the distance between the wireless transceivers 220B and the magnetic field center. Further, although both the wireless transceivers 220A and 220B are outside the imaging space, the wireless transceiver 220B is closer to the wireless transceiver 310 and there is no obstacle (as a result, the quality evaluation result in the preliminary measurement is also determined to be better for the wireless transceiver 220B), so that the processor 410 selects the wireless transceiver 220B.

Fig. 9C is an example of a case in which the leg is imaged. In this example, although the wireless transceiver 220B is closer to the imaging part, the wireless transceiver 220B enters the imaging space and is closer to the magnetic field center. On the other hand, the wireless transceiver 220A is far from the magnetic field center and is outside the imaging space (as a result, the quality evaluation result in the preliminary measurement is also determined to be better for the wireless transceiver 220A), so that the processor 410 selects the wireless transceiver 220A.

Fig. 9D is an example of wide area imaging (here, it is assumed that the chest and abdomen are imaged). In this example, the distance between the wireless transceiver 220A and the imaging part is approximately the same as the distance between the wireless transceiver 220B and the imaging part, and the distance between the wireless transceiver 220A and the magnetic field center is approximately the same as the distance between the wireless transceivers 220B and the magnetic field center. Further, although both the wireless transceivers 220A and 220B are outside the imaging space, in this example, since two receive coils 110D and 110E are used, the processor 410 selects the wireless transceivers 220A and 220B (first wireless transceivers) and selects the wireless transceivers 310A and 310B in consideration of the communication amount.

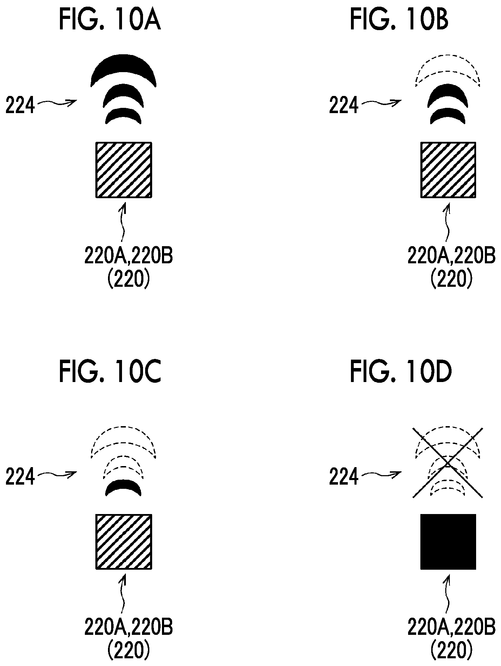

The processor 410 outputs information indicating the selected wireless transceiver and information indicating the quality of the wireless communication via the selected wireless transceiver (step S160). For example, the information can be displayed on a display or the like of the output device 460. Figs. 10A to 10D are examples of quality display, and the quality is indicated by the number of arc-shaped figures 224. As the number of the figures 224 increases, the quality is higher (the quality is higher in the order of Fig. 10A to Fig. 10C), and, in a case in which the communication is disconnected, the portion of the wireless transceiver is filled as in Fig. 10D, and a cross mark is added to the figure 224

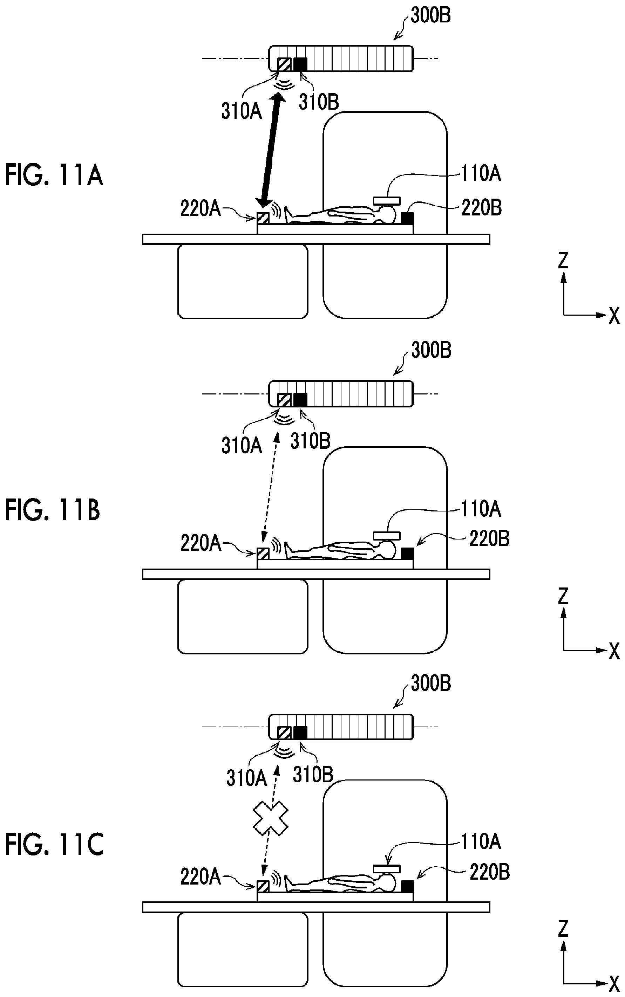

Figs. 11A to 11C are diagrams showing another example of the quality display. In Figs. 11A to 11C, an example of a case in which the filter box 300B is installed on the ceiling is shown. Fig. 11A shows that the wireless transceiver 220A and the wireless transceiver 310A are selected, and the quality of wireless communication between these wireless transceivers is high, in which a thickness of an arrow connecting the wireless transceiver 220A and the wireless transceiver 310A represents a quality level. Fig. 11B shows a state in which the quality of the wireless communication is lower than that in the case of Fig. 11A, and this state is represented by a thin dotted line. Fig. 11C shows a state in which the wireless communication is disconnected, and this state is indicated by a cross mark. The quality of the wireless communication may be displayed by color, a number, a graph, or the like, or may be output by voice from the speaker of the output device 460.

With the quality display of the wireless communication or the identification display of the wireless transceiver, the user can easily know the quality of the wireless communication or which wireless transceiver is selected and is operating.

The processor 410 turns off the operation of the non-selected wireless transceivers (may turn off the power) and operates only the selected wireless transceiver (step S170), and starts main imaging (step S180). It is preferable that the processor 410 displays the non-selected wireless transceivers and the non-operating wireless transceivers in an identifiable manner together with the quality display of the wireless communication described above.

In the above-described aspect, only the selected wireless transceiver is operated, but the non-selected wireless transceivers may also be operated to enable rapid switching.

### Case in which Wireless Communication Is Disconnected or Quality of Wireless Communication Is Deteriorated

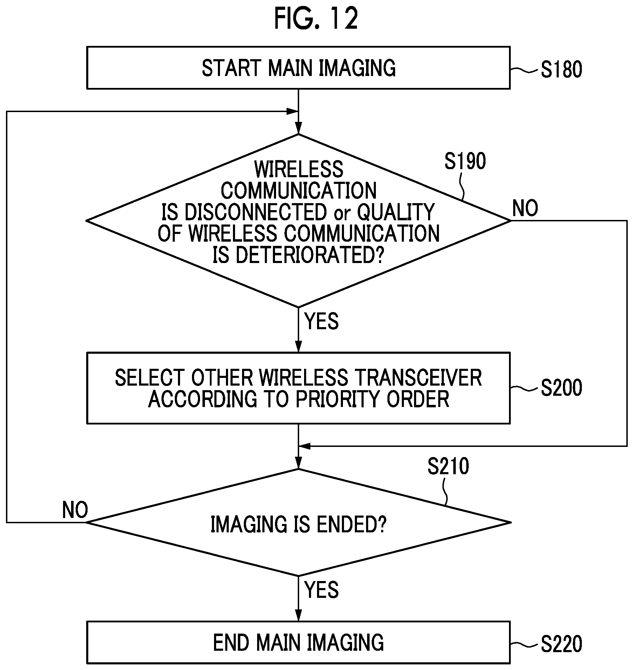

Since the magnetic resonance imaging apparatus 10 according to the first embodiment comprises the plurality of wireless transceivers 220A and 220B (first wireless transceivers), the wireless transceiver can be switched in a case in which the wireless communication is disconnected or the quality of the wireless communication is deteriorated. Fig. 12 is a flowchart showing processing of switching the wireless transceiver. In a case in which the wireless communication is disconnected or the quality of the wireless communication is deteriorated (YES in step S190), the processor 410 selects a wireless transceiver other than the wireless transceiver selected in step S150 (the wireless transceiver other than the first wireless transceiver) according to the priority order (step S200) and continues the wireless communication. For example, in a case in which the wireless communication is disconnected or the quality of the wireless communication is deteriorated while the wireless transceiver 220A is selected, the processor 410 selects the wireless transceiver 220B, which is a "wireless transceiver other than the wireless transceiver 220A", and continues the wireless communication.

The processing related to the switching of the wireless transceiver continues until the scheduled imaging is ended (until YES in step S210 and the processing proceeds to step S220). In a case in which the communication quality of the wireless transceiver that is to be selected in step S200 is not good, the processor 410 may stop the switching, output a message, and stop the imaging.

In this process, it is assumed that the priority order is set in advance for the wireless transceivers as described above in step S150.

### Second Embodiment

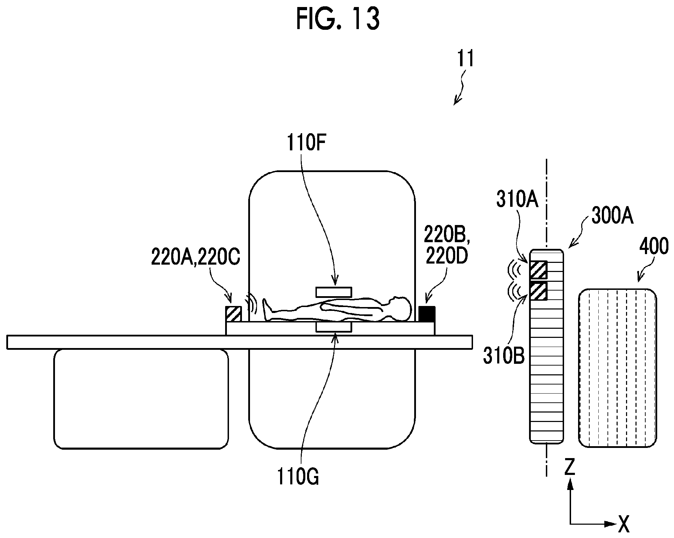

In the first embodiment described above, the wireless transceivers 220A and 220B are respectively installed at both ends of the top plate 210 in the longitudinal direction, but the disposition of the wireless transceivers (first wireless transceivers) in the present invention is not limited to such an aspect. As will be described below, a plurality of wireless transceivers (first wireless transceivers) may be disposed at each different position in the longitudinal direction of the top plate 210. For example, as in a magnetic resonance imaging apparatus 11 shown in Fig. 13, two wireless transceivers (wireless transceivers 220A and 220C, and 220B and 220D) may be installed at each end part (different positions in the longitudinal direction) of the top plate 210. In the filter box 300, two wireless transceivers 310A and 310B (second wireless transceivers) can be installed accordingly. Fig. 13 shows a case in which two receive coils 110F and 110G are used.

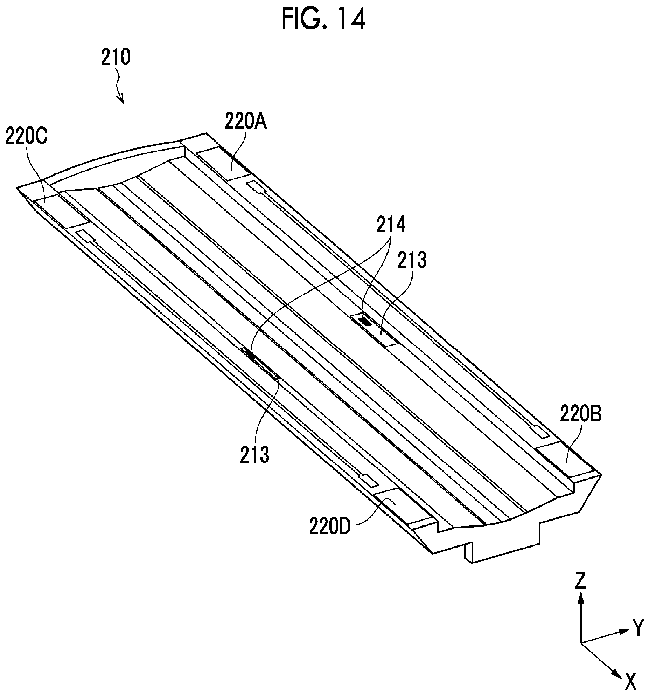

Fig. 14 is an external perspective view showing disposition of the wireless transceivers 220A to 220D on the top plate 210. As shown in Fig. 14, the wireless transceivers 220A and 220C (+Y side and -Y side) are installed at an -X side end part of the top plate 210, and the wireless transceivers 220B and 220D (+Y side and -Y side) are installed at a +X side end part. As described above for the first embodiment, it is preferable that the wireless transceivers 220A to 220D are housed in the top plate 210 or integrated with the top plate 210.

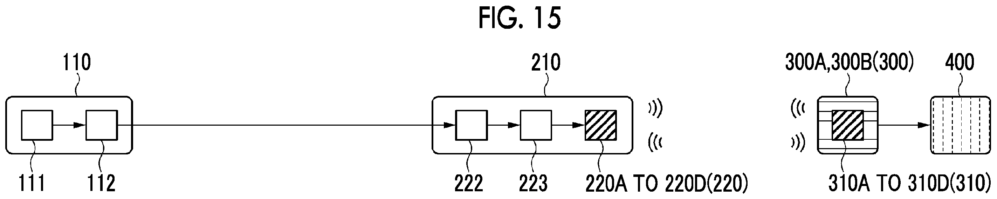

Fig. 15 is a conceptual diagram showing a state of wireless communication in a second embodiment. As shown in Fig. 15, the receive coil 110A (receive coil 110; RF coil unit) comprises a plurality of element coils 111 and an amplifier 112, and is connected to the top plate 210 by a cable (and the connector 214 shown in Fig. 14). A signal from the receive coil 110A (receive coil 110) acquired via the cable is converted into a digital optical signal by the AD converter 222 and the optical converter 223, and is transmitted by the wireless transceiver 220. Since the wireless communication is bidirectionally performed, the wireless transceiver 220 transmits and receives an optical signal, and the optical converter 223 performs EO conversion and OE conversion. In a case of wireless communication using radio waves, the optical converter 223 is not necessary. The signal transmitted from the wireless transceiver 220 is received by the wireless transceiver 310 provided in the filter box 300 and is input to the control device 400 (input/output interface 470, processor 410; see Fig. 6). The control signal from the control device 400 is transmitted through a path opposite to the above-described path.

In the second embodiment having the above-described configuration, similarly to the first embodiment, the wireless transceiver can be selected to perform the wireless communication, and high-quality wireless communication can be performed to acquire the magnetic resonance image. In addition, since two wireless transceivers are installed at each end part of the top plate 210, a degree of freedom in selecting the wireless transceivers according to the imaging part, the quality of the wireless communication, and the like is improved. The configuration of the second embodiment can be adopted, for example, in a case in which the wireless communication is performed simultaneously using a plurality of coils as in Fig. 13 or in a case in which the imaging range is wide.

### Third Embodiment

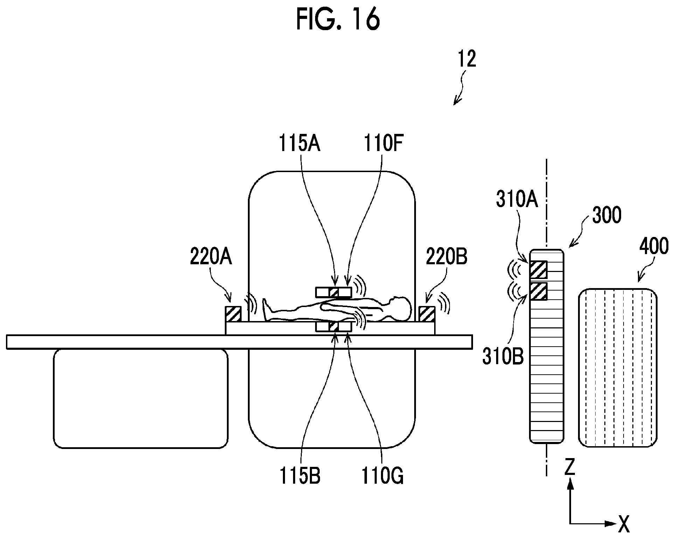

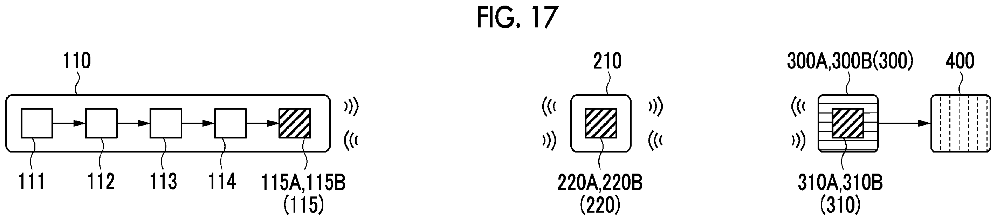

In the first and second embodiments described above, the receive coil 110 (RF coil) and the wireless transceiver 220 (first wireless transceiver) on the top plate 210 side are connected by a cable, but the wireless transceiver may be connected to the receive coil 110, and at least one of the wireless transceivers 220 may be connected to the receive coil 110 by wireless communication. For example, as in a magnetic resonance imaging apparatus 12 shown in Fig. 16, a wireless transceiver 115A (third wireless transceiver) is provided in the receive coil 110F, a wireless transceiver 115B (third wireless transceiver) is provided in the receive coil 110G, and the wireless communication can be performed between the wireless transceivers 115A and 115B and the wireless transceivers 220A and 220B on the top plate 210 side. According to the third embodiment, similarly to the first and second embodiments, it is possible to perform high-quality wireless communication to capture the magnetic resonance image. In addition, according to the third embodiment, since the wireless communication can be performed between the wireless transceivers 115A and 115B and the wireless transceivers 220A and 220B, it is possible to reduce the number of physical cables, thereby reducing the influence on the subject 99. A state of the wireless communication in the third embodiment is shown in a conceptual diagram of Fig. 17.

In the third embodiment, similarly to the second embodiment, a plurality of wireless transceivers (first wireless transceivers) may be provided at each end of the top plate 210.

### Others

Although the embodiments of the present invention have been described above, the present invention is not limited to the above-described embodiments and various modifications can be made within the scope of the invention as defined by the claims.

### Explanation of References

10: magnetic resonance imaging apparatus
99: subject
100: imaging apparatus main body
102: static magnetic field generation source
104: gradient magnetic field coil
106: irradiation coil
110A: receive coil
200: bed device
210: top plate
211: top plate receiver
220A: wireless transceiver
220B: wireless transceiver
240: bed main body
242: top plate locking mechanism
244: top plate drive mechanism
310A: wireless transceiver
310B: wireless transceiver
400: control device
Steps S100 to S180: each process for selecting wireless transceiver

## Claims

1. A magnetic resonance imaging apparatus comprising:
a top plate (210) on which a subject is placed, the top plate being slidable in a longitudinal direction;
a plurality of first wireless transceivers (200A, 200B) connected to a receive coil (110A) for capturing a magnetic resonance image of the subject, the plurality of first wireless transceivers being provided at a plurality of positions of the top plate in the longitudinal direction and moving in the longitudinal direction as the top plate slides;
a second wireless transceiver (310A, 310B); and
a controller (400) that selects at least one of the plurality of first wireless transceivers and performs wireless communication using the selected first wireless transceiver and the second wireless transceiver.

2. The magnetic resonance imaging apparatus according to claim 1,
wherein at least one of the first wireless transceivers (200A) is provided at an end part of the top plate (210) in the longitudinal direction, and at least one of the first wireless transceivers (200B) is provided at the other end part of the top plate in the longitudinal direction.

3. The magnetic resonance imaging apparatus according to claim 1 or 2,
wherein the plurality of first wireless transceivers (200A, 200B) are disposed at both end parts of the top plate (210) in the longitudinal direction.

4. The magnetic resonance imaging apparatus according to any one of claims 1 to 3,
wherein at least one of the plurality of first wireless transceivers (200A, 200B) is connected to the receive coil (110A) by wireless communication.

5. The magnetic resonance imaging apparatus according to any one of claims 1 to 4,
wherein the controller (400) performs the selection based on quality of wireless communication between the first wireless transceivers and the second wireless transceiver.

6. The magnetic resonance imaging apparatus according to any one of claims 1 to 5,
wherein the controller (400) performs the selection based on a result of preliminary measurement before performing main imaging of the subject.

7. The magnetic resonance imaging apparatus according to any one of claims 1 to 6,
wherein the controller (400) performs the selection in consideration of a relationship between a size of an imaging space of the magnetic resonance imaging apparatus in the longitudinal direction and an interval between the plurality of positions in the longitudinal direction.

8. The magnetic resonance imaging apparatus according to any one of claims 1 to 7,
wherein an interval between the plurality of positions in the longitudinal direction is longer than a longitudinal length of an imaging space of the magnetic resonance imaging apparatus, and, in a state in which the subject is imaged, at least one of the plurality of first wireless transceivers (200A, 200B) is located outside the imaging space.

9. The magnetic resonance imaging apparatus according to any one of claims 1 to 8,
wherein the controller (400) selects a first wireless transceiver located outside an imaging space of the magnetic resonance imaging apparatus from among the plurality of first wireless transceivers.

10. The magnetic resonance imaging apparatus according to any one of claims 1 to 9,
wherein the controller (400) performs the selection in consideration of an imaging part of the subject.

11. The magnetic resonance imaging apparatus according to any one of claims 1 to 10,
wherein the controller (400) performs the selection in further consideration of a direction in which the subject is placed on the top plate.

12. The magnetic resonance imaging apparatus according to any one of claims 1 to 11,
wherein the controller (400) operates only the selected first wireless transceiver among the plurality of first wireless transceivers in the wireless communication.

13. The magnetic resonance imaging apparatus according to any one of claims 1 to 12,
wherein the controller (400)
selects a plurality of first wireless transceivers from among the plurality of first wireless transceivers, and
sets a priority order in the wireless communication for the selected first wireless transceivers to perform the wireless communication based on the priority order.

14. The magnetic resonance imaging apparatus according to any one of claims 1 to 13,
wherein, in a case in which the wireless communication is disconnected or quality of the wireless communication is deteriorated, the controller selects at least one of first wireless transceivers other than the selected first wireless transceiver among the plurality of first wireless transceivers and performs the wireless communication.

15. The magnetic resonance imaging apparatus according to any one of claims 1 to 14,
wherein the controller (400) causes an output device (460) to output information indicating the selected first wireless transceiver among the plurality of first wireless transceivers,
and/or
wherein the controller causes an output device to output information indicating quality of the wireless communication.
